Europäisches Patentamt

European Patent Office

Office européen des brevets

(19)

(11) **EP 0 944 141 A2**

(12) **EUROPEAN PATENT APPLICATION**

(43) Date of publication:
22.09.1999 Bulletin 1999/38

(51) Int. Cl.$^6$: **H01S 3/06**

(21) Application number: 98310760.8

(22) Date of filing: 24.12.1998

(84) Designated Contracting States:
AT BE CH CY DE DK ES FI FR GB GR IE IT LI LU
MC NL PT SE
Designated Extension States:
AL LT LV MK RO SI

(30) Priority: 25.12.1997 JP 35593097

(71) Applicant: NEC CORPORATION
Tokyo (JP)

(72) Inventor: Yoneyama, Kenichi
Tokyo (JP)

(74) Representative:
Goodman, Simon John Nye et al
Reddie & Grose,
16 Theobalds Road
London WC1X 8PL (GB)

(54) **Optical amplifier**

(57) A wavelength selection type reflection device is interposed between an exciting LD device and an optical isolator. The wavelength selection type reflection device reflects, among wavelengths of exciting light emitted from the exciting LD device, only specific wavelengths capable of exciting the active fiber with the highest efficiency and returns them to the exciting LD device. The above constitution can realize an exciting laser module that causes no significant change in wavelengths of the exciting light upon a temperature change. This in turn can provide an optical amplifier that can realize highly stable operation independently of a fluctuation in environmental temperature and can be applied to applications where high reliability is required, such as submarine repeaters.

FIG.3

EP 0 944 141 A2

## Description

FIELD OF THE INVENTION

The invention relates to an optical amplifier provided with an active fiber, comprising an optical fiber with a dopant being added to a core portion thereof, that can absorb exciting light having specific wavelengths to amplify signal light having wavelengths different from the wavelengths of the exciting light.

BACKGROUND OF THE INVENTION

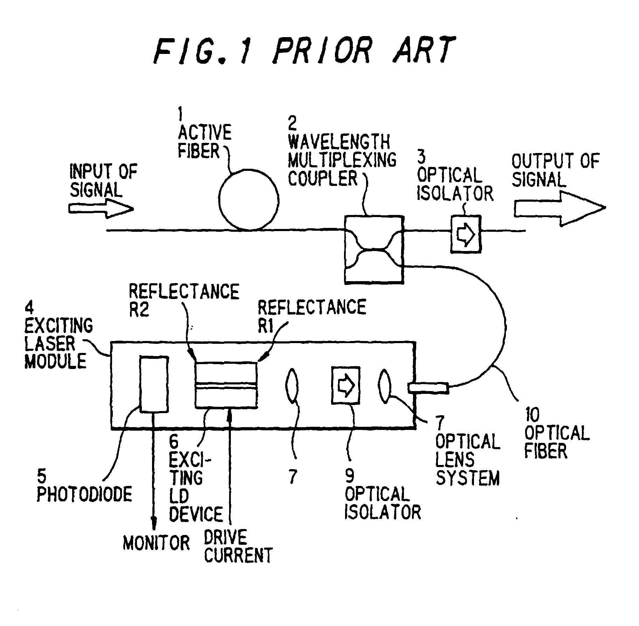

Examples of optical amplifiers provided with an active fiber are disclosed in Yoshihiro Konishi, "Hikari Faiba Tushin Gijutu (Optical Fiber Communication Techniques)," Chapter 10, p. 197-220, published by The Nikkan Kogyo Shimbun, Ltd. on June 26, 1995. A typical example thereof is shown in Fig. 1.

Referring to Fig. 1, an active fiber 1, which is an optical amplification fiber, comprises an optical fiber with a dopant being added to a core portion thereof. By virtue of the addition of the dopant to the core portion, the active fiber can absorb exciting light having specific wavelengths to amplify signal light having wavelengths different from the wavelengths of the exciting light. In this optical amplifier, a wavelength multiplexing coupler 2 is provided for efficiently introducing exciting light into the active fiber 1 without causing no significant loss of the signal light. Numeral 3 designates an optical isolator for signal light.

Numeral 4 designates an exciting laser module that generates exciting light for exciting the active fiber 1. The exciting laser module 4 comprises an exciting LD (laser diode) device 6 and an optical lens system 7 for efficiently coupling the exciting light output from the exciting LD device 6 to the terminal of an optical fiber 10.

The module 4 further comprises a photodiode 5 for a monitor that monitors output power from the end of the fiber to the exciting LD device 6.

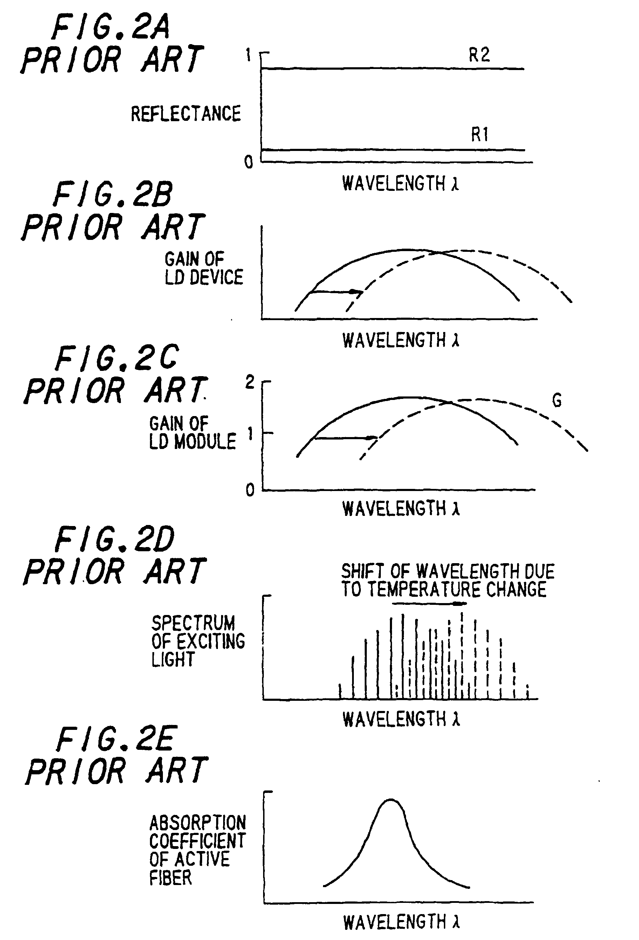

The reflectance of the outgoing face and the reflectance of the reflecting face in the exciting LD device 6 are respectively R1 and R2. As shown in FIG. 2A, R1 is several %, and R2 about 90%.

The reason why an optical isolator 9 is provided within the exciting laser module is the prevention of such an unfavorable phenomenon that, upon entry of lights into the exciting LD device 6 through the end of the fiber, the state of operation of the exciting LD device 6 is varied rendering the power of the exciting light output unstable. Lights which enter the exciting LD device 6 through the terminal of the fiber, include exciting light returned as a result of reflection or scattering within the optical amplifier, leaked noise light (ASE: amplified spontaneous emission) generated within the active fiber 1, and leaked amplified signal light.

Regarding the conventional optical amplifier, the first problem is that, upon a fluctuation in environmental temperature, the optical amplifier cannot be satisfactorily stably operated. The reason for this is as follows. The fluctuation in environmental temperature brings about a fluctuation in temperature of the exciting laser device. This in turn causes a change in wavelengths of the exciting light output from the exciting laser. In this case, when the range of absorption wavelengths of the exciting light, which is absorbed by the active fiber, is narrow, wavelengths of the exciting light are deviated from the absorption wavelength range of the active fiber, making it impossible for the optical amplifier to perform satisfactorily stable optical amplification operation.

For example, in the case of currently used typical erbium-doped fiber amplifiers, the exciting light wavelength absorption range for 1480 nm band is relatively broad being from 1450 to 1490 nm, while the exciting light wavelength absorption range for 980 nm band is as narrow as 5 nm. Therefore, when an exciting laser of 980 nm band is used as an excitation source, the exciting laser should not cause a fluctuation in wavelength upon a fluctuation in environmental temperature. In general, at the present time, in order to solve the above problem, the temperature is controlled by cooling the exciting laser device by means of a Peltier cooler to keep the temperature of the exciting laser device constant independently of a fluctuation in environmental temperature.

When the optical amplifier is used in applications where very high reliability is required of apparatuses and parts, such as submarine repeaters, however, the Peltier cooler cannot be used because the reliability of the Peltier cooler is low. Therefore, in order to cope with the use of active fibers having a narrow exciting light absorption range, the development of the construction of an optical amplifier capable of realizing both high reliability and stable operation independently of a fluctuation in temperature has been desired in the art.

SUMMARY OF THE INVENTION

Accordingly, it is an object of the invention to provide an optical amplifier that can realize highly stable operation independently of a fluctuation in environmental temperature and can be applied to applications where high reliability is required, such as submarine repeaters.

According to the first feature of the invention, an optical amplifier, comprises an active fiber, the active fiber comprising an optical fiber with a dopant being added to a core portion thereof, the active fiber being adapted for absorbing exciting light having specific wavelengths to amplify signal light having wavelengths different from the wavelengths of the exciting light,

the exciting light being emitted by means comprising:

an exciting laser device;

a wavelength selection type reflection device that reflects only specific wavelengths among wavelengths of the exciting light output from the exciting laser device and returns them to the exciting laser device; and

exciting light introduction means that introduces the light output from the wavelength selection type reflection device into the active fiber.

The exciting light introduction means preferably comprises: an optical isolator that sends the light output from the wavelength selection type reflection device toward only the active fiber; an optical lens system that permits the input of the light output from the optical isolator; and an introduction optical fiber for introducing the light output from the optical lens system into the active fiber.

According to the second feature of the invention, an optical amplifier, comprises:

an active fiber comprising an optical fiber with a dopant being added to a core portion thereof, the active fiber being adapted for absorbing exciting light having specific wavelengths to amplify signal light having wavelengths different from the wavelengths of the exciting light;

a wavelength multiplexing coupler that introduces the exciting light into the active fiber toward signal light;

an exciting laser module that generates exciting light for exciting the active fiber,

wherein the exciting laser module comprises:

an exciting laser device;

an optical lens system that couples the exciting light from the exciting laser device to the terminal of the optical fiber;

an optical isolator that inhibits the entry of light from the terminal of the optical fiber into the exciting laser device, the optical isolator being provided between the exciting laser device and the terminal of the optical fiber; and

a wavelength selection type reflection device that reflects only specific wavelengths among wavelengths of the exciting light and returns them to the exciting laser device, the wavelength selection type reflection device being provided between the exciting laser device and the optical isolator.

The wavelength selection type reflection device is preferably set so that the reflectance of the exciting light at the specific wavelengths is 10% to several %. The reflecting wavelength band of the specific wavelengths in the wavelength selection type reflection device is not more than 2 nm.

The active fiber is preferably an erbium-doped fiber. The exciting light preferably has wavelengths falling within a band of 975 to 985 nm or a band of 1450 to 1490 nm. The signal light in the active fiber has wavelengths falling within a band of 1500 to 1600 nm.

The function of the invention will be explained. The wavelength selection type reflection device interposed between the exciting laser device and the optical isolator is designed so as to reflect only light having specific wavelengths that can excite the active fiber with the highest efficiency. Further, setting of the reflectance of the light at the specific wavelengths to about several % for optimization can realize the construction of a laser resonator between the exciting laser device and the wavelength selection type reflection device. In this case, the reflectance on the outgoing surface of the exciting laser device should be satisfactorily lower than the reflectance of the wavelength selection type reflection device.

The laser resonator between the exciting laser device and the wavelength selection type reflection device is formed only in the above specific wavelengths. Therefore, no laser resonator is formed for light having other wavelengths generated by the exciting laser device. This permits laser oscillation, from the exciting laser module, of only light having specific wavelengths that can excite the active fiber with the highest efficiency.

In this case, even though the operation wavelength of the exciting laser device is somewhat shifted due to a fluctuation in environmental temperature, the laser oscillation at the same wavelength can be advantageously continued as long as the amplification factor of wavelengths for which a resonator is constructed by the wavelength selection type reflection device is not remarkably lowered. Therefore, the adoption of the above construction can realize the provision of an optical amplifier that, even when the temperature fluctuates, does not cause a fluctuation in wavelengths of the exciting light. Further, in this case, the operation of the optical amplifier per se is stable against the fluctuation in temperature.

BRIEF DESCRIPTION OF THE DRAWINGS

The invention will be explained in more detail in conjunction with appended drawings, wherein:

FIG. 1 is a diagram showing a conventional optical amplifier;

FIGs. 2A to 2E are graphs showing characteristics relative to wavelengths in the conventional optical amplifier;

FIG. 3 is a diagram showing an optical amplifier according to a preferred embodiment of the invention; and

FIGs. 4A to 4E are graphs showing characteristics relative to wavelengths in an optical amplifier according to a preferred embodiment of the invention.

## DESCRIPTION OF THE PREFERRED EMBODIMENTS

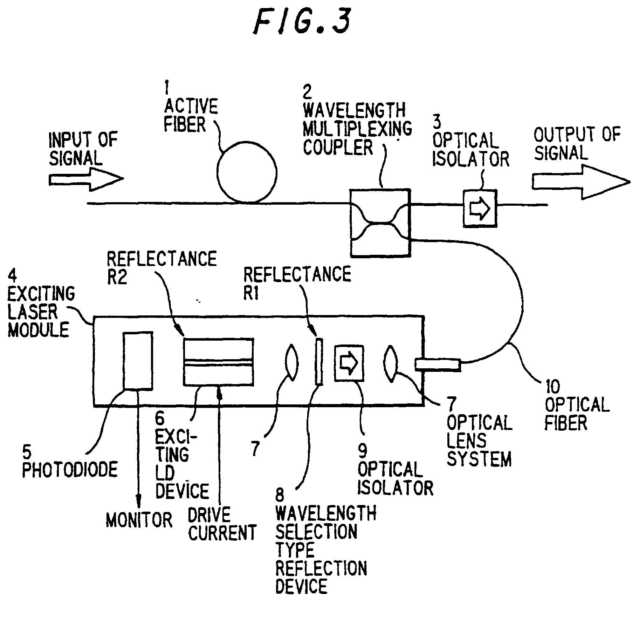

FIG. 3 is a diagram showing an optical amplifier according to a preferred embodiment of the invention. In FIGs. 1 and 3, like parts are identified with the same reference numerals. The optical amplifier shown in FIG. 3 is different from the optical amplifier shown in FIG. 1 in that, in FIG. 3, within the exciting laser module, a wavelength selection type reflection device 8 is interposed between the exciting LD device 6 and the optical isolator 9. This wavelength selection type reflection device 8 reflects, among wavelengths of exciting light emitted from the exciting LD device 6, only specific wavelengths capable of exciting the active fiber 1 with the highest efficiency and returns them to the exciting LD device 6.

The optical isolator 3 inserted into an output port of the signal light prevents signal light output from the optical amplifier being reflected from the transmission path and returned to within the active fiber 1. This can realize stable operation of the optical amplifier without being influenced by reflected return light from the outside thereof. In this preferred embodiment, an optical isolator is inserted into only the output port. The optical isolator may also be inserted into an input port for the same purpose.

The other construction than explained above is the same as the construction of the optical amplifier shown in FIG. 1.

The operation of the optical amplifier shown in FIG. 3 will be explained. The active fiber 1 is designed as follows. The exciting light input through the wavelength multiplexing coupler 2 is absorbed, and the signal light is amplified by stimulated emission utilizing the stored energy. The exciting laser module 4 constructs a laser resonator between the wavelength selection type reflection device 8, interposed between the exciting LD device 6 and the optical isolator 9, and the backside of the exciting LD device 6, permitting laser to be forcibly oscillated at specified wavelengths.

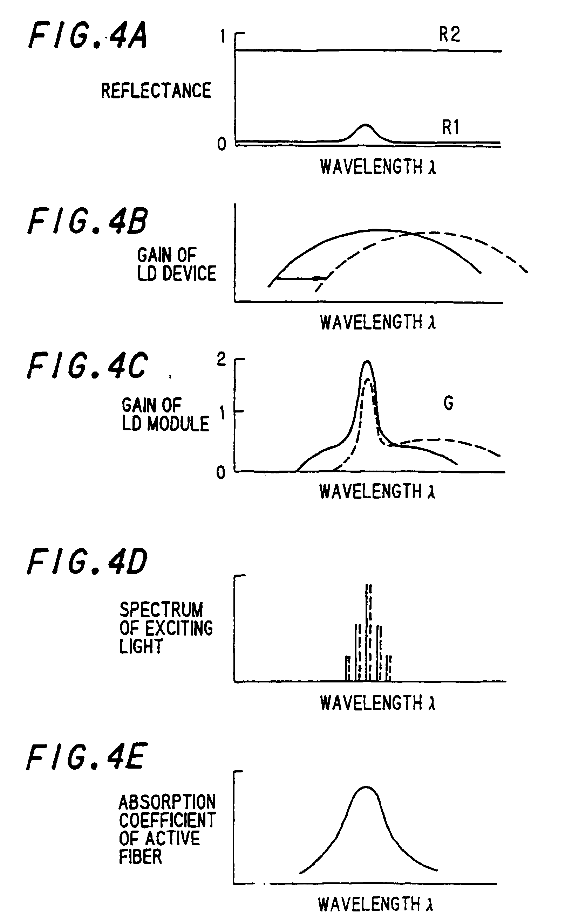

FIGs. 2A to 2E are graphs showing characteristics relative to wavelengths in the conventional optical amplifier, and FIGs. 4A to 4E graphs showing characteristics relative to wavelengths in an optical amplifier according to a preferred embodiment of the invention. The abscissa represents the wavelength. The backward reflectance R2 of the exciting LD resonator represents the reflectance of the backside of the exciting LD device 6. The forward reflectance R1 of the exciting LD resonator represents the front reflectance of the exciting LD device 6 in the case of the conventional optical amplifier and represents the reflectance of the wavelength selection type reflection device 8 in the case of the optical amplifier of the preferred embodiment of the invention.

For the conventional optical amplifier, the forward reflectance R1 is a reflectance (10 to several %) which is uniform independently of the wavelength. On the other hand, the forward reflectance in the case of the optical amplifier according to the preferred embodiment of the invention is such that the reflectance is several % for only specific wavelengths, while the reflectance for the other wavelengths is limited to a low value. Therefore, laser oscillation conditions are satisfied at only specific wavelengths for which the reflectance of the exciting laser module wavelength selection type reflection device is several %. Upon a change in environmental temperature, the gain G of the exciting LD device is shifted toward the wavelength (FIG. 2B).

For the conventional optical amplifier, since the wavelength characteristics of the exciting LD module gain vary according to a change in wavelength of the gain for the exciting LD device (FIG. 2C), the laser oscillation wavelength also varies (FIG. 2D). On the other hand, for the optical amplifier of the preferred embodiment of the invention, even though the wavelength characteristics of the gain for the device has been varied (FIG. 4C), the reflectance R1 is, for example, several % for only the specific wavelengths. Therefore, laser oscillation does not occur at wavelengths other than the specific wavelengths (the laser oscillation occurs when the gain of the exciting LD module ( =G*G*R1*R2 ) exceeds 1). In fact, the laser oscillation occurs when matching conditions for the axial mode of the laser resonator are met. Therefore, as is apparent from a spectrum of the exciting light as shown in FIG. 4D, fine axial mode oscillation is aligned.

FIG. 2E is a graph showing the relationship between the wavelengths of exciting light and the exciting light absorption coefficient of the active fiber for the conventional optical amplifier, and FIG. 4B is a graph showing the relationship between the wavelengths of exciting light and the exciting light absorption coefficient of the active fiber for the optical amplifier of the embodiment. For the conventional optical amplifier, the wavelengths of the exciting light are shifted with the temperature change and deviated from the absorption wavelength band of the active fiber. whereas, for the embodiment, the exciting light wavelengths are stable against the temperature change and always conform to the absorption wavelength band of the active fiber.

When an erbium-doped fiber is used in the active fiber, in many cases, a high-output LD module of 1480 nm band (1450 to 1490 nm) or 980 nm band (975 to 985 nm) is used as the exciting light source. In this case, for the 980 nm band, the absorption wavelength band of the active fiber is as narrow as 5 nm, and, hence, the exciting light wavelength stabilizing technique of the invention is particularly important.

Use of optical devices, such as optical band reflection filters (notch filters) of a narrow band or diffraction gratings, is considered effective as means for realizing the wavelength selection type reflection device. The reflection bandwidth of the wavelength selection type reflection device is brought to not more than 2 nm to realize a mode-locked operation at a narrow line width. The reflectance of the wavelength selection type reflection device is brought to about several %, and the operation of exciting laser at a high output with high stability can be expected by optimization.

As described above, according to the preferred embodiment of the invention, a wavelength selection type reflection device is provided within an exciting LD laser module to remain laser oscillation wavelengths unchanged independently of the temperature change. Therefore, the operation of the optical amplifier is advantageously stable against a change in environment.

Further, according to the preferred embodiment of the invention, any device having low reliability, such as a Peltier cooler, is not used for the stabilization of the exciting light wavelengths. Therefore, the optical amplifier according to the invention is best suited also for applications where high reliability is required, such as submarine repeaters.

The invention has been described in detail with particular reference to preferred embodiments, but it will be understood that variations and modifications can be effected within the scope of the invention as set forth in the appended claims.

**Claims**

1. An optical amplifier comprising an active fiber, the active fiber comprising an optical fiber with a dopant being added to a core portion thereof, the active fiber being adapted for absorbing exciting light having specific wavelengths to amplify signal light having wavelengths different from the wavelengths of the exciting light,

   the exciting light being emitted by means comprising:
   an exciting laser device;
   a wavelength selection type reflection device that reflects only specific wavelengths among wavelengths of the exciting light output from the exciting laser device and returns them to the exciting laser device; and
   exciting light introduction means that introduces the light output from the wavelength selection type reflection device into the active fiber.

2. The optical amplifier according to claim 1, wherein the exciting light introduction means comprises: an optical isolator that sends the light output from the wavelength selection type reflection device toward only the active fiber; an optical lens system that permits the input of the light output from the optical isolator; and an introduction optical fiber for introducing the light output from the optical lens system into the active fiber.

3. An optical amplifier comprising:

   an active fiber comprising an optical fiber with a dopant being added to a core portion thereof, the active fiber being adapted for absorbing exciting light having specific wavelengths to amplify signal light having wavelengths different from the wavelengths of the exciting light;
   a wavelength multiplexing coupler that introduces the exciting light into the active fiber toward signal light;
   an exciting laser module that generates exciting light for exciting the active fiber,
   wherein the exciting laser module comprises:
   an exciting laser device;
   an optical lens system that couples the exciting light from the exciting laser device to the terminal of the optical fiber;
   an optical isolator that inhibits the entry of light from the terminal of the optical fiber into the exciting laser device, the optical isolator being provided between the exciting laser device and the terminal of the optical fiber; and
   a wavelength selection type reflection device that reflects only specific wavelengths among wavelengths of the exciting light and returns them to the exciting laser device, the wavelength selection type reflection device being provided between the exciting laser device and the optical isolator.

4. An optical amplifier according to any one of claims 1 to 3, wherein the wavelength selection type reflection device is set so that the reflectance of the exciting light at the specific wavelengths is 10% to several %.

5. The optical amplifier according to any one of claims 1 to 3, wherein the reflecting wavelength band of the specific wavelengths in the wavelength selection type reflection device is not more than 2 nm.

6. The optical amplifier according to any one of claims 1 to 5, wherein the active fiber is an erbium-doped fiber.

7. The optical amplifier according to any one of claims 1 to 6, wherein the exciting light has wavelengths falling within a band of 975 to 985 nm or a band of 1450 to 1490 nm.

8. The optical amplifier according to any one of claims 1 to 7, wherein the signal light in the active fiber has wavelengths falling within a band of 1500 to 1600 nm.

## FIG. 1 PRIOR ART

# FIG.2A PRIOR ART

REFLECTANCE

R2

R1

WAVELENGTH λ

# FIG.2B PRIOR ART

GAIN OF LD DEVICE

WAVELENGTH λ

# FIG.2C PRIOR ART

GAIN OF LD MODULE

G

WAVELENGTH λ

# FIG.2D PRIOR ART

SPECTRUM OF EXCITING LIGHT

SHIFT OF WAVELENGTH DUE TO TEMPERATURE CHANGE

WAVELENGTH λ

# FIG.2E PRIOR ART

ABSORPTION COEFFICIENT OF ACTIVE FIBER

WAVELENGTH λ

# FIG.3

INPUT OF SIGNAL

1 ACTIVE FIBER

2 WAVELENGTH MULTIPLEXING COUPLER

3 OPTICAL ISOLATOR

OUTPUT OF SIGNAL

REFLECTANCE R2

REFLECTANCE R1

4 EXCITING LASER MODULE

5 PHOTODIODE

6 EXCITING LD DEVICE

MONITOR

DRIVE CURRENT

8 WAVELENGTH SELECTION TYPE REFLECTION DEVICE

7

9 OPTICAL ISOLATOR

7 OPTICAL LENS SYSTEM

10 OPTICAL FIBER

# FIG.4A

REFLECTANCE

1 — R2

0 — R1

WAVELENGTH $\lambda$

# FIG.4B

GAIN OF
LD DEVICE

WAVELENGTH $\lambda$

# FIG.4C

GAIN OF
LD MODULE

2

1

G

0

WAVELENGTH $\lambda$

# FIG.4D

SPECTRUM
OF EXCITING
LIGHT

WAVELENGTH $\lambda$

# FIG.4E

ABSORPTION
COEFFICIENT
OF ACTIVE
FIBER

WAVELENGTH $\lambda$